# EUROPEAN PATENT SPECIFICATION

(11) **EP 4 027 526 B1**
(45) Date of publication and mention of the grant of the patent: **10.06.2026**
(21) Application number: 21150721.5
(22) Date of filing: 08.01.2021
(51) Int. Cl.: H04B 1/00, H01Q 3/00, H04B 1/04, H04B 1/18

(54) **CAPACITIVE TUNER MODULE AND METHOD OF MANUFACTURING THE SAME**
KAPAZITIVES TUNER-MODUL UND VERFAHREN ZUR HERSTELLUNG DAVON
MODULE DE SYNTONISEUR CAPACITATIF ET SON PROCÉDÉ DE FABRICATION

(43) Date of publication of application: 13.07.2022
(73) Proprietor: Infineon Technologies AG, 85579 Neubiberg (DE)
(72) Inventor: FU, Li, Beijing, 100068 (CN); WANG, Kun, 85635 Höhenkirchen-Siegertsbrunn (DE); HUANG, Cheng Yu, 115 Taipei (TW); SHAO, Xiaodong, Shanghai, 703 (CN)
(74) Representative: Kraus & Lederer PartGmbB

(56) References cited:
- EP-A1- 2 819 308
- EP-A2- 2 651 032
- EP-B1- 2 651 032

## Description

### TECHNICAL FIELD

The present application relates to capacitive tuner modules and manufacturing such tuner modules.

In radio frequency (RF) applications, tuning circuits are coupled to an antenna for antenna tuning. Capacitive tuning circuits used in this respect include one or more capacitors which may selectively be coupled to the antenna for tuning. Such tuning circuits may be provided in form of a module including switches and capacitors. Also in other radio frequency applications, similar tuning approaches where capacitors are selectively connected to an element to be tuned are employed.

The tuning circuit topology employed depends on various factors like design, parasitic effects like hand-head effects in case of mobile phones (i.e. effects resulting by the hand holding the mobile phone approaching the head of a user), antenna materials used in case of antenna tuning, just to mention a few. Due to this variety, a plurality of different tuning circuits have be manufactured and employed by antenna designers and RF device manufacturers like mobile phone manufacturers. For some tuning applications, conventionally more than one integrated circuit is used, which may cause performance degradation of the tuned element like an antenna.

### RELATED PRIOR ART

Document EP2819308A1 discloses an antenna impedance matching apparatus, semiconductor chip, and method. Document EP2651032A2 describes a tunable capacitor.

### SUMMARY

The invention is defined in the independent claims. The dependent claims define additional embodiments.

### BRIEF DESCRIPTION OF THE DRAWINGS

Fig. 1 is a diagram of a capacitive tuner module according to an embodiment.
Figs. 2, 3, 4A to 4F and 5 illustrate capacitive tuner modules according to various embodiments.
Figs. 6A and 6B show equivalent circuits for simulation purposes.
Figs. 7A and 7B illustrate an application example for the capacitive tuner module of Fig. 5.
Figs. 8A and 8B show a comparative example, and Figs. 8C and 8D show an application example for the capacitive tuner module of Fig. 5.
Figs. 9A and 9B show a comparative example, and Figs. 9C and 9D show an application example for the capacitive tuner module of Fig. 5.
Figs. 10A and 10B show a comparative example, and Figs. 10C and 10D show an application example for the capacitive tuner module of Fig. 5.
Figs. 11A and 11B illustrate a further example of the capacitive tuner module of Fig. 5.
Fig. 12 illustrates a method according to some embodiments.

### DETAILED DESCRIPTION

In the following various embodiments will be described in detail referring to the attached drawings. These embodiments are given for illustration purposes and are not to be construed as limiting in any way. For example, while embodiments may include a plurality of features (components, elements, acts, events, devices etc.), in other embodiments some of these features or elements may be omitted or replaced by alternative features or elements. In addition to the features explicitly shown and described, other features, for example features used in conventional radio frequency devices and tuning circuits or modules may be provided.

Variations or modifications described with respect to one of the embodiments are also applicable to other embodiments unless noted otherwise and therefore will not be described repeatedly. Features from different embodiments may be combined unless noted otherwise.

Connections or couplings as used herein refer to electrical connections or couplings unless noted otherwise. Such connections or couplings may be modified, for example by providing additional elements or by removing elements, as long as the general purpose of the connection or coupling is maintained, for example to provide a certain kind of control, to transmit a signal, to provide a voltage or current and the like.

Some embodiments described herein relate to capacitive tuner modules. A module, as used herein, is a separate entity which may be incorporated in devices like semiconductor devices. The entity may be a chip, a plurality of chips provided in a single package, a single chip provided in a package or other housing. A module generally has a plurality of terminals allowing an electrical connection between the module and other elements of a device, for example to an antenna, to a radio frequency source, etc. While modules are described in some of the embodiments below, the corresponding circuits included in the modules may also be integrated together with other elements and connected to a tunable element.

A capacitive tuner module includes one or more capacitors. These capacitors in some application examples may be coupled to an element to be tuned, for example an antenna, via one or more of the terminals of the module.

Capacitors discussed in the embodiments below may be single capacitors, an array of capacitors, tunable capacitors, a capacitor block etc.

Capacitive tuner modules according to embodiments described herein also include one or more switches. In some applications, such switches may be used to selectively couple capacitors to an element to be tuned. In other embodiments, switches may be used to selectively provide a connection to external elements coupled to the capacitive tuner modules. Switches may be implemented as transistor switches using one or more transistors like bipolar junction transistors (BJTs), field effect transistors (FETs) like metal oxide semiconductor field effect transistors (MOSFETs), or insulated gate bipolar transistors (IGBTs). Transistor switches may include a plurality of transistors cells to enable switching of higher voltages or currents. A switch is described as closed or on when it provides a low ohmic connection between its terminals. A switch is described as open or off if it essentially provides an electrical isolation between terminals, apart from possible very small leakage currents which may occur in real implementation of switches and which, if present, are several orders of magnitude smaller than currents flowing in the on-state of the switch. Other switch blocks, which may be formed by a combination of transistor switches, may also be used as switches described herein.

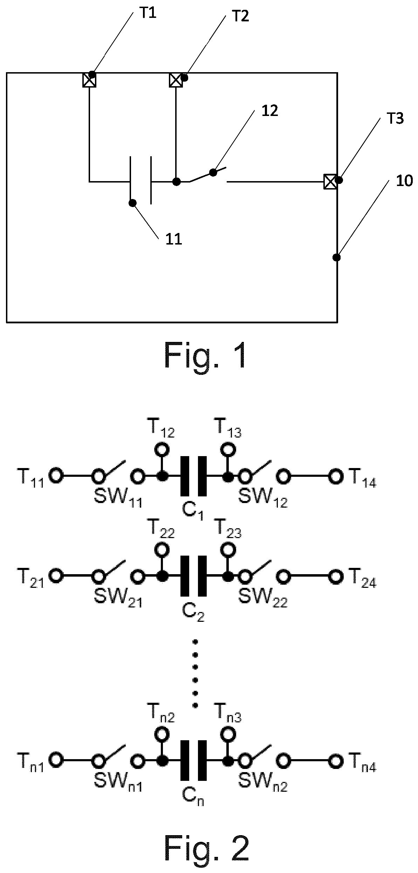

Turning now to the figures, Fig. 1 is a diagram of a capacitive tuner module 10 according to some embodiments. Capacitive tuner module 10 in the example of Fig. 1 includes a capacitor 11 and a switch 12. Capacitor 11 and switch 12 are coupled in series between a first terminal T1 and a third terminal T3. Furthermore, a node between capacitor 11 and switch 12 is coupled to a second terminal T2.

This connection of capacitor 11 and switch 12 allows a versatile use of capacitive tuner module 10. For instance, coupling for example first terminal T1 to an element to be tuned like an antenna and then terminal T3 to ground, switch 12 may be used to selectively activate capacitor 11 for tuning or deactivate capacitor 11. The addition of second terminal T2 allows further uses. For example, using first terminal T1 and second terminal T2, capacitor 11 may be simply connected between ground and an element to be tuned, or accessed for other purposes. Furthermore, using second terminal T2 and third terminal T3, switch 12 may be used separately, for example to switch an additional external tuning element like an external tuning capacitor that may be provided in addition to capacitor 11.

Therefore, the provision of second terminal T2 allows additional uses besides such switching capacitor 11 using switch 12. By this increased versatility, capacitive tuner module 10 may be used for more different applications, without having to provide separate tuning modules. Being able to use the same capacitive tuning module for various applications, on the other hand, may make manufacturing thereof more efficient.

Fig. 2 illustrates a capacitive tuner circuit, that may be provided in a module, according to an embodiment.

The capacitive tuner circuit of Fig. 2 comprises n capacitors C₁ to Cₙ, where n may be equal to or larger than 1, i.e. in some embodiments a single capacitor (in this case C₁) may be provided. Each capacitor Cₖ, k = 1...n, in the embodiment of Fig. 2 has two switches SWₖ₁ and SWₖ₂ associated therewith, which couple the respective capacitor C₁ to terminals Tₖ₁ and Tₖ₄. In other embodiments, for each capacitor C₁ to Cₙ one of the switches SWₖ₁ or SWₖ₂ may or may not be omitted. In this case, the corresponding terminal Tₖ₁ or Tₖ₄ may also be omitted.

Furthermore, a node between each respective capacitor Cₖ and associated switch SWₖ₁ is coupled to a terminal Tₖ₂, and a node between each respective capacitor Tₖ and the associated switch SWₖ₂ is coupled to a terminal Tₖ₃.

Taking capacitor C₁ as an example, in this way switches SW₁₁ and SW₁₂ may be used to selectively couple capacitor C₁ to terminal T₁₁ and T₁₄, respectively. Furthermore, for example switch SW₁₁ may be used alone for switching external elements using terminals T₁₁ and T₁₂, switch SW₁₂ may be used alone to switch external elements using terminals T₁₃ and T₁₄, and terminals T₁₂ and T₁₃ may be used to access capacitor C₁ without switches. This enables a versatile use of each capacitor Cₖ similar to what was explained for capacitor 11 of Fig. 1.

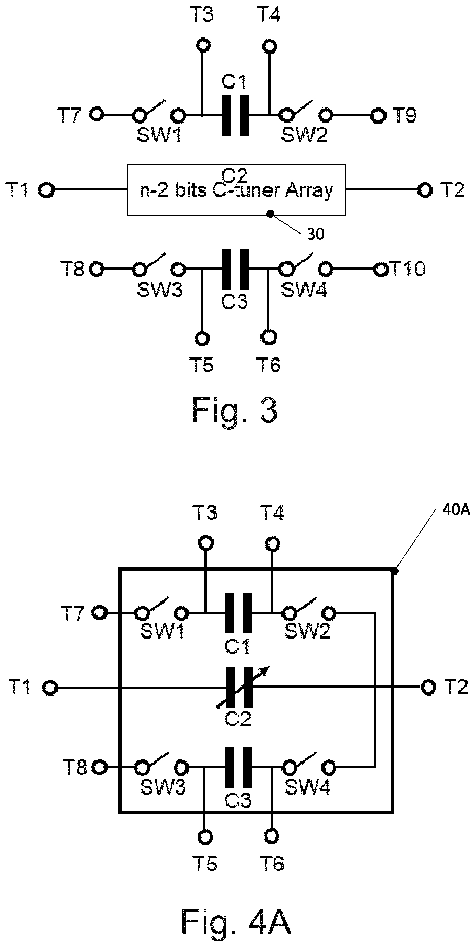

Fig. 3 illustrates a capacitive tuner module according to a further embodiment.

The module of Fig. 3 comprises a first capacitor C1 and a third capacitor C3. First capacitor C1 is coupled with switches SW1, SW2 and terminals T7, T3, T4 and T9 and capacitor C3 is coupled to switches SW3, SW4 and terminals T8, T5, T6 and T10 in the same manner as each capacitor Cₖ is coupled to switches SWₖ₁, SWₖ₂ and Terminals Tₖ₁ to Tₖ₄ in Fig. 2, with the same flexible use as already described for Fig. 2. Additionally, as a second capacitor C2 a tunable n-2 bits capacitive tuner array is provided between terminals T1 and T2. Such a capacitive tuner array essentially is a tunable capacitance which may be adjusted with an n-2 bits control signal. Any known tunable capacitance implementation can be used, for example based on further switches and capacitors. This allows additional tuning flexibility and shows that in addition to capacitors connected as described with respect to Figs. 1 and 2, additional tuning capacitors, in this case second capacitor C2, may be provided in embodiments.

Figs. 4A to 4F show modules 40A to 40F according to various embodiments. Capacitive tuner modules 40A to 40E comprise three capacitors C1, C2 and C3, where C2 is a tunable capacitor like the capacitive tuner array 30 of Fig. 3. Capacitive tuner module 40F includes only capacitors C1 and C2. Essentially, the modules 40A to 40F are variations of the module discussed with reference to Fig. 3, and will be described referring thereto. Furthermore, in Figs. 4A to 4F, SW1 to SW4 denote switches, and T1 to T10 are terminals of the respective capacitive tuner modules.

In capacitive tuner module 40A of Fig. 4A, ends of switches SW2, SW4 are also coupled to terminal T2 and not to separate terminals T9 and T10 as in Fig. 3. Otherwise, the configuration of Fig. 4A corresponds to the one of Fig. 3.

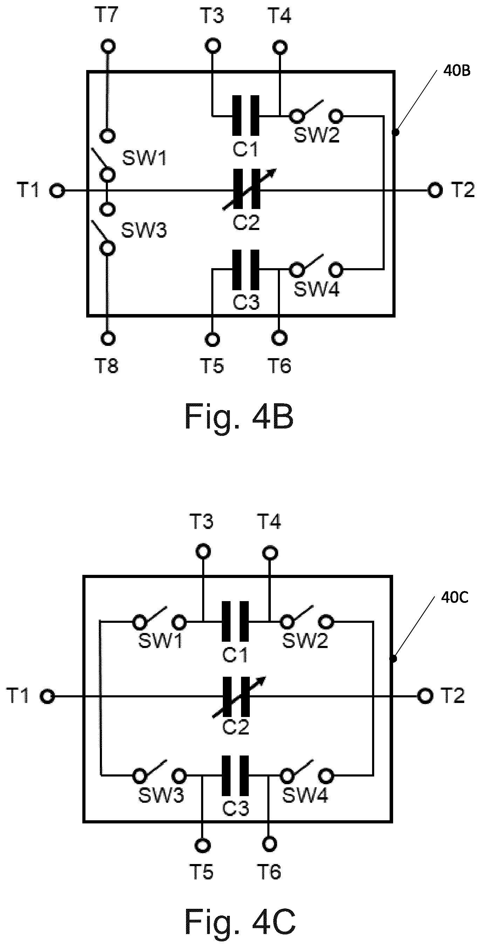

In capacitive tuner module 40B of Fig. 4B, capacitor C1 is not coupled to switch SW1, but only to terminal T3, and capacitor C3 is coupled only to terminal T5, but not to switch SW3. Switch SW1 is coupled between terminal T7 and capacitor C2 and switch SW3 is coupled between terminal T8 and adjustable capacitor C2 as shown.

In capacitive tuner module 40C of Fig. 4C, compared to Fig. 3, terminals T7, T9, T8 and T10 are omitted and switches SW1 and SW3 are coupled to terminal T1 as shown and switches SW2 and SW4 are coupled to terminal T2 as shown.

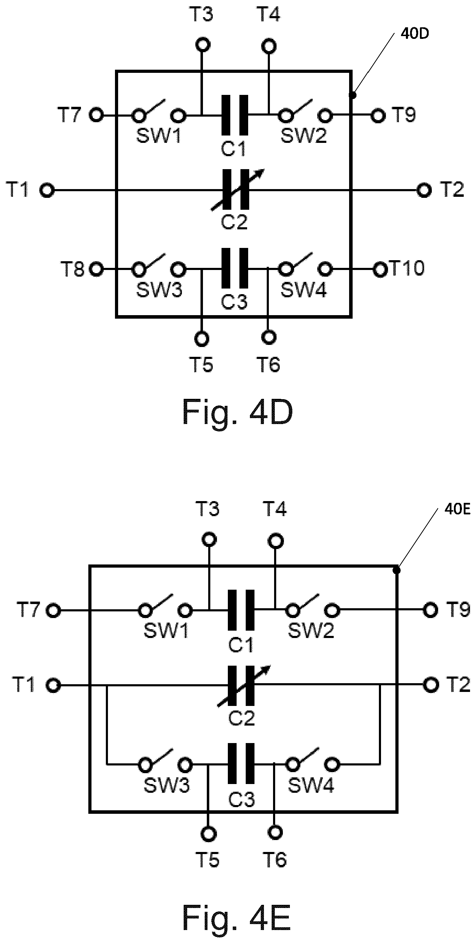

Capacitor tuner module 40D of Fig. 4D essentially corresponds to Fig. 3, with the exception that capacitor C2 is represented as general tunable capacitor and not limited to the n-2 bits capacitive tuner array 30 of Fig. 3.

Fig. 4E is essentially a combination of the embodiments of Figs. 4C and 4D, where capacitor C1 of capacitive tuner modules 40E is coupled as in Fig. 4D and capacitor C3 of capacitive tuner module 40E is coupled as capacitor C3 of Fig. 4C.

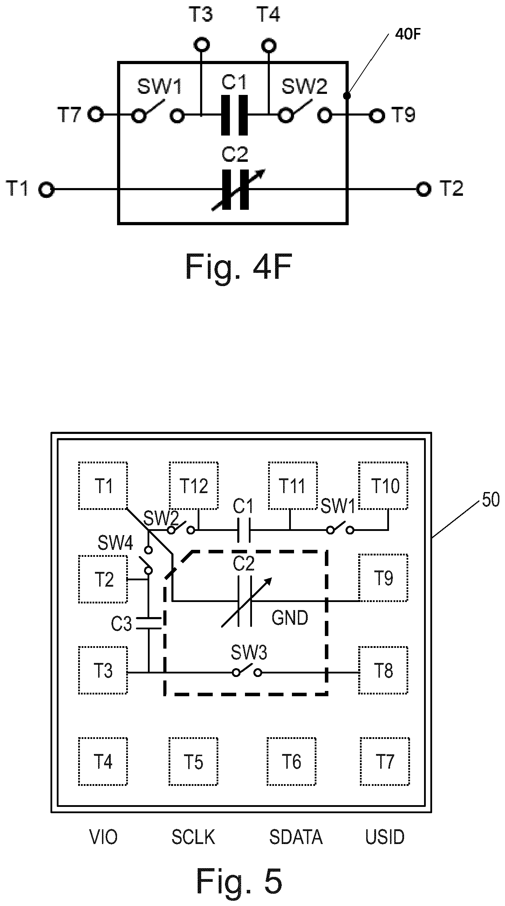

Capacitive tuner modules as discussed above may have further terminals for controlling switches used, like switches SW1 to SW4 of Figs. 4A to 4F, or to set capacitance values of variable capacitors as for example capacitors C2 in Figs. 4A to 4F. An embodiment of a corresponding capacitive tuner module 50 is illustrated in Fig.5. The modules may include a control logic or other circuitry like drivers to control the switches and tunable capacitors based on such control signals.

Capacitive tuner module 50 of Fig. 5 has twelve terminals T1 to T12. Terminals T4 to T7 are input/output terminals for communication and control of capacitive tuner module 50, for receiving Signals VIO, SCLK, SDATA and USID according to the MIPI standard, where VIO is a power supply of the module, SCLK and SDATA are a clock signal and a data signal, respectively, and USID is a user identification.

The remaining terminals T1 to T3 and T8 to T12 are used to connect to a switch and capacitor arrangement which in the example of Fig. 5 corresponds to the arrangement of capacitive tuner module 40A of Fig. 4A. Switches SW1 to SW4 and capacitors C1 to C3 of Fig. 5 correspond to SW1 to SW4 and C1 to C3 of Fig. 4A. Due to the consecutive numbering of the terminals in Fig. 5, the numbering of the terminals differ from the one in Fig 4A. Terminal T1 of Fig. 5 corresponds to terminal T2 of Fig. 4A, terminal T2 corresponds to terminal T6 of Fig. 4A, terminal T3 of Fig. 5 corresponds to terminal T5 of Fig. 4A, terminal T8 of Fig. 5 corresponds to terminal T8 of Fig. 4A, terminal T9 of Fig. 5 corresponds to terminal T1 of Fig. 4A, terminal T10 of Fig. 5 corresponds to terminal T7 of Fig. 4A, terminal T11 of Fig. 5 corresponds to terminal T3 of Fig. 4A, and terminal T12 of Fig. 5 corresponds to terminal T3 of Fig. 4A.

In the following, the versatility of capacitive tuner module 50 for various applications will be discussed using various application examples, which have been simulated. While capacitive tuner module 50 is used as an example here, it is to be understood that this is merely for illustration purposes, and in other embodiments, other capacitive tuner modules with different configurations of switches and capacitors may be used, for example based on capacitive tuner modules 40B to 40F of Figs. 4B to 4F instead of being based on capacitive tuner module 40A of Fig. 4A.

For the application examples discussed in the following, some numerical values will be given for elements used (e.g. capacitances) and for properties based on simulations. These numerical values serve only for illustration purposes to give an impression of some possible properties of some implementations and are not to be construed as limiting, as they may depend on specific implementations of components like switches or capacitors.

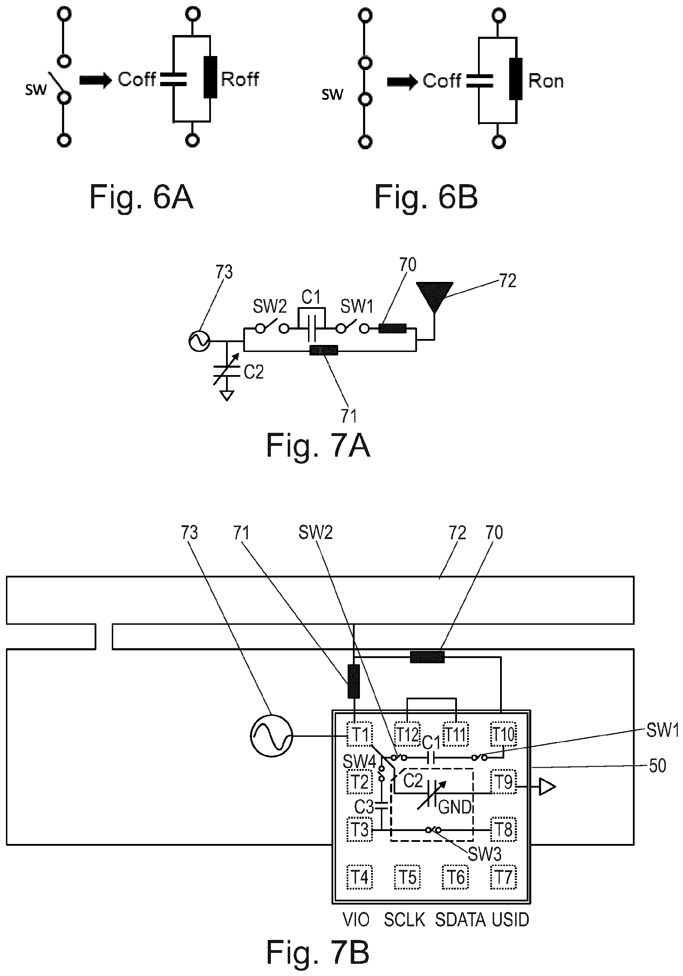

For simulation purposes, as shown in Fig. 6A, an open switch SW is treated as a parallel connection of an off-capacitance Coff and an off-resistance Roff. A closed switch SW, as shown in Fig. 6B, is simulated as a parallel connection between the off-capacitance Coff (which is essentially treated as being the same in the on- and off-state) and an on-resistance Ron. In switches Ron typically is several orders of magnitude smaller than Roff.

C1 in the simulation was treated as a capacitance having a capacitance of 0.5 pF and a q factor of 60 for frequencies smaller than 1 GHz and a q factor of 50 for frequencies between 1 and 3 GHz. For C3, a capacitance value of 1 pF was used, with the same q factor as for C1. For C2 a tunable capacitance range from 0.5 to 4 pF was assumed with a step size of 0.15 pF (5 bits control) and a q factor of 35 of frequencies smaller than 1 GHz and of 30 for frequencies between 1 and 3 GHz. For switches SW1, SW2, SW3 and SW4, an on-resistance Ron of 0.8 Ω, an off-resistance Roff of 30 kΩ and an off-capacitance Coff of 0.2 pF was used for simulations.

As mentioned above, these are merely example values that may depend on implementations.

Fig. 7, including Figs. 7A and 7B, shows a first application example of capacitive tuner module 50 of Fig. 5. Fig. 7A shows a circuit diagram, and Fig. 7B illustrates how to implement such a circuit diagram using capacitive tuner module 50 of Fig. 5.

In the application example of Fig. 7, two switches SW1 and SW2 of capacitive tuner module 50 are used in series to provide a high voltage from a radio frequency source 73 to an antenna 72. Radio frequency source 73 may for example provide a signal to be transmitted using antenna 72. As can be seen in Fig. 7B, antenna 72 may be realized as a suspended element above a substrate. Other antenna implementations may also be used. Besides capacitive tuner module 50, two external inductors 70, 71 are used in the example of Fig. 7. In an example used for simulations, inductor 70 had an inductance of 6.2 nH, and inductor 71 had an inductance of 13 nH.

In Fig. 7B, it can be seen how by using terminals T1, T12, T11, T10 and T9, the configuration of Fig. 7A may be realized using capacitive tuner module 50. As shown in Fig. 7B, terminal T1 is coupled to radio frequency source 73 and to inductor 71, terminal T10 is coupled to inductor 70, and terminals T12 and T11 are directly electrically coupled with each other. Terminal T9 is coupled to ground. By such a configuration, a voltage applied by radio frequency source 73 in case both switches SW1 and SW2 are closed is distributed between the switches. For example, an overall voltage of 46 V across switches SW1, SW2 results in a voltage drop of only 23 V across each of the switches, which enables the use of switches designed for lower voltages. For tuning, for example depending on a frequency band used, capacitor C2 may be adjusted, and switches SW1, SW2 may be both off or both on. For example, in a first frequency band between 880 and 960 MHz, referred to as LB, switches SW1 and SW2 are off, and C2 is set to 4 pF, whereas for a second frequency frequency band between 1710 and 2170 MHz, referred to as MB, switches SW1, SW2 are switched on, and C2 is set to 2.2 pF. Switches SW3 and SW4 are not used in this configuration and are always off.

For the first frequency band, for example the antenna scattering parameter S11 was about -13 to -15 dB for frequencies slightly below 1 GHz, and for the second frequency band S22 has a minimum between -25 and -30 dB slightly below 2 GHz, and is -11.5 dB at 1.71 GHz and - 10.45 dB at 2.17 GHz.

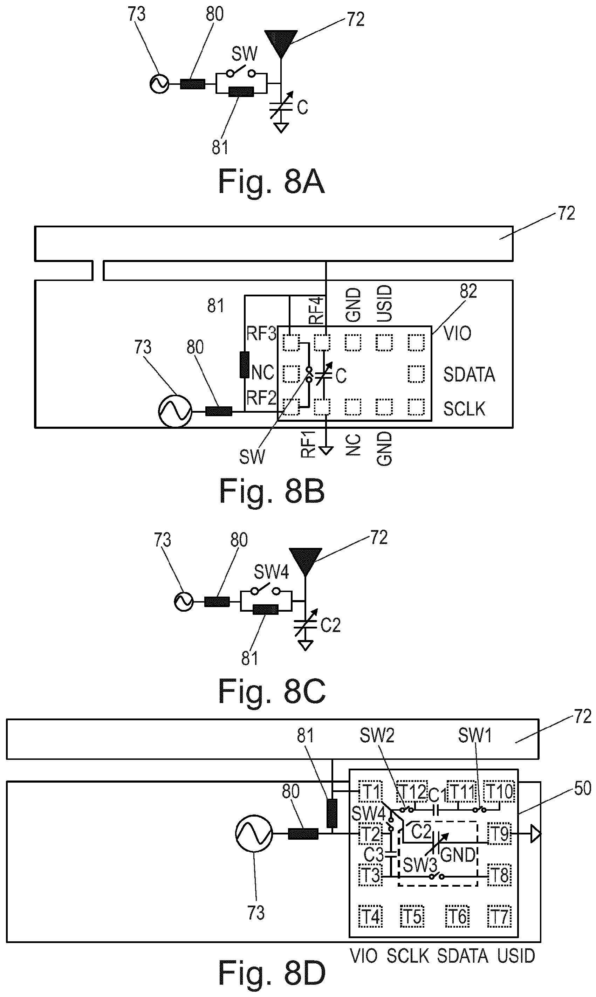

Fig. 8, including Figs. 8A to 8D, shows a further application example. Fig. 8A shows a circuit diagram for a comparative example, and Fig. 8B illustrates realization of the circuit diagram of Fig. 8A with a conventional tuning module 82. Fig. 8C shows a circuit diagram for an implementation with capacitive tuner module 50 of Fig. 5, and Fig. 8D illustrates a possible realization of the circuit of Fig. 8C with the capacitive tuner module 50.

The configuration of Fig. 8 is a capacitive tuner in a shunt configuration with a switch used to bypass an inductance. As an element to be tuned, again an antenna 72 is used and a radio frequency source 73 provides a radio frequency signal. Figs. 8A and 8B illustrate the configuration using a conventional tuner module 82 including a tunable capacitor C and a switch SW. In addition, external inductors 80, 81 are used, where for example inductor 80 has an inductivity of 7 nH and inductor 81 has a inductivity of 8 nH. Inductor 81 may be bypassed by closing switch SW. Capacitor C is provided in a shunt configuration between antenna 72 and ground and may be tuned for example in a range of 0.17 to 4 pF.

As shown in Figs. 8C and 8D the same configuration may be obtained using capacitive tuner module 50. Here, of capacitive tuner module 50, in the example of Fig. 8D only switch SW4 and capacitor C2 are used. Inductor 81 is coupled between terminals T1 and T2 of capacitive tuner module 50, and inductor 80 is coupled between RF source 73 and terminal T2. Terminal T9 is coupled to ground. As can be seen in Fig 8C, in this way, using for example SW4 and C2 essentially the same circuit diagram as in Fig. 8 may be obtained.

The size of conventional module 82 used for this purpose is for example 2.0x1.1 mm, whereas a size for capacitive tuner module 50 may for example be 1.5x1.5 mm. For tuning the antenna 72 to the first frequency band, the switch (SW in Figs. 8A and 8B and SW4 in Figs. 8C and 8D) is switched off, and the adjustable capacitor (C in Figs. 8A and 8B, C2 in Figs. 8C and 8D) is set to 1.7 pF. For the second frequency band, the respective switch is switched on, and the respective tunable capacitor is set to 0.8 pF.

The overall space consumption therefore is comparable. For the power loss in the device, for the first frequency band the power loss at 30 dBm input is comparable for both devices, about 106 mW for the conventional case of Figs. 8A and 8B and 108 mW for the embodiment Figs. 8C and 8D. For the second frequency band, the losses were 125 mW for the conventional implementation of Figs. 8A and 8B, and only 89 mW for the embodiment of Figs. 8C and 8D.

The power saving is due to the reconfigurable topology of module 50. For example, one can optimize the performance of tuning circuit. For the example of Figs. 8C and 8D, inductor 81 is bypassed by low ON mode resistance switch SW4 to achieve lower power loss.

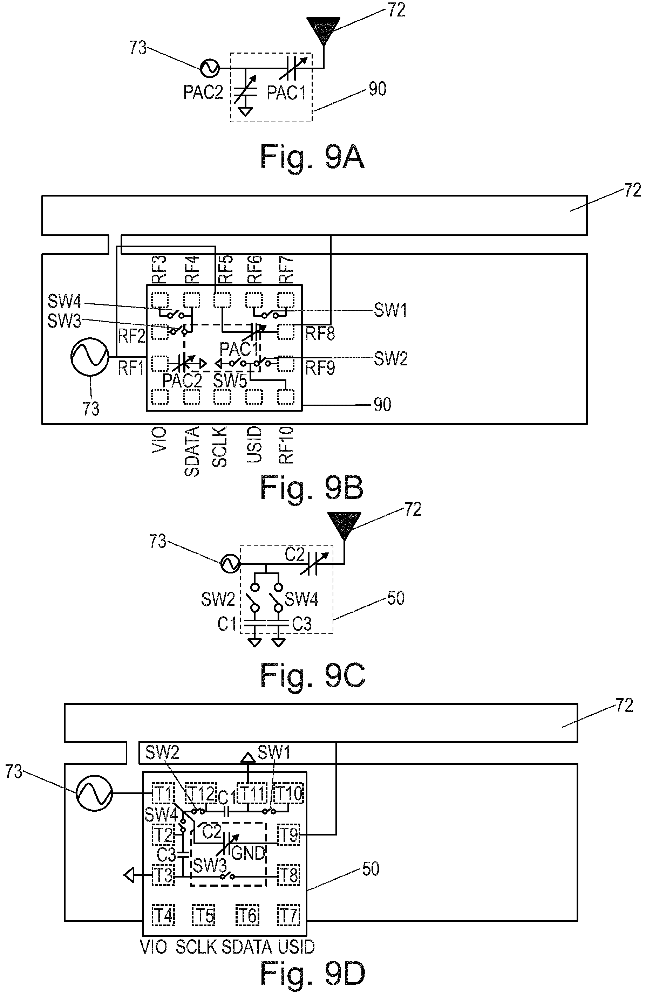

Fig. 9 shows a further application of capacitive tuner module according to an embodiment. Similar to Fig. 8, Fig. 9A shows a circuit diagram for a comparative example, Fig. 9B shows an implementation of the circuit diagram of Fig. 9A with a conventional capacitive tuner module 90, Fig. 9C shows a circuit diagram of an implementation using capacitive tuner module 50, and Fig. 9D shows an arrangement for implementing the circuit diagram of Fig. 9C.

In Fig. 9, a combination of shunt capacitor and series capacitor for tuning is used. In Fig. 9A, again a radio frequency source 73 and an antenna 72 are provided as an example environment. For tuning, an adjustable capacitor PAC1 is coupled in series between radio frequency source and antenna 72, and an adjustable capacitor PAC2 is coupled between radio frequency source 73 and ground.

The conventional tuner module 90 used for this application includes switches and tunable capacitors, of which only the tunable capacitors PAC1 and PAC2 are used.

Fig. 9C shows a circuit implementation using capacitive tuner module 50. Here, capacitor C2 is used as a tunable series capacitance, corresponding to PAC1 of Fig. 9A. To provide a tunable shunt capacitance, C1 is coupled in series with switch SW2 between radio frequency source 73 and ground, and capacitor C3 and switch SW4 are also coupled in series between radio frequency source 73 and ground. This provides a further adjustable capacitor similar to capacitor PAC2 of Fig. 9A by selectively opening and closing switches SW2 and SW4. Fig. 9D shows the corresponding connections. Terminal T9 is coupled to antenna 72, terminal T1 is coupled to radio frequency source 73, and terminals T3 and T11 are coupled to ground.

The size of conventional module 90 is 2.0·1.6 mm, i.e. larger than an implementation example of capacitive tuner module 50 (1.5·1.5 mm as discussed above). For the conventional case of Figs. 9A and 9B, for the same first and second frequency bands as defined above (LB and MB), for the first frequency band PAC1 is set to 4 pF and PAC2 to 1.5 pF, and for the second frequency band PAC1 is set to 0.5 pF and PAC2 to 1 pF. In order to obtain a similar effect for the embodiment of Figs. 9C and 9D, for the first frequency band switches SW2 and SW4 are switched on and C2 is set to 4 pF, and for the second frequency band SW2 is switched off, SW4 is switched on, and C2 is set to 0.5 pF.

Losses are similar for both cases, at 30 dBm input about 55 mW for the first frequency band and about 115 mW for the second frequency band. However, the embodiment of Figs. 9C and 9D requires less area and therefore may lead to lower costs.

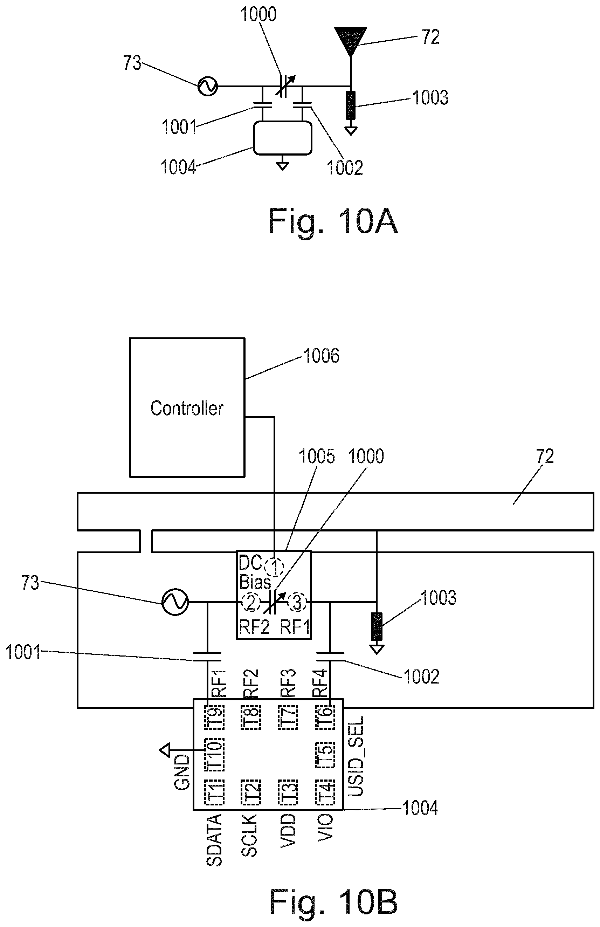

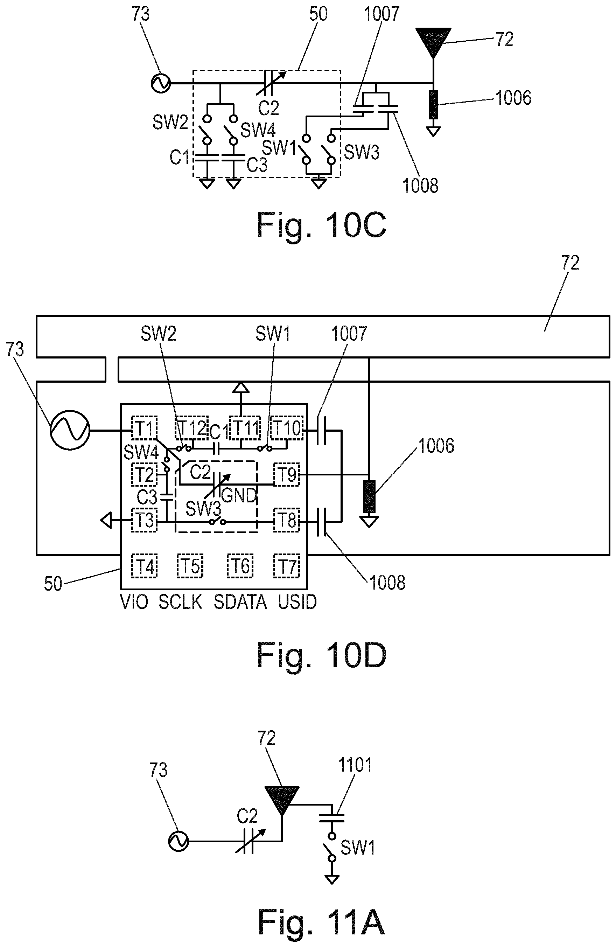

Fig. 10, including Figs. 10A to 10D, illustrates a further comparative example and application example for the capacitive tuner module 50 of Fig. 5. Fig. 10A shows a circuit diagram of a comparative example, Fig. 10B shows an implementation of the comparative example using modules 1004, 1005 and a controller 1006, Fig. 10C shows a circuit diagram of a corresponding implementation using a capacitive tuner module 50, and Fig. 10D shows an implementation example using capacitive tuner module 50.

As shown in Fig. 10A, in this tuning approach, an adjustable capacitance 1000 is coupled between radio frequency source 73 and antenna 72. An inductor 1003 is coupled in a shunt configuration between antenna 72 and ground. Furthermore capacitors 1001, 1002 are coupled to ground via module 1004, which may be used to selectively switch capacitors 1001, 1002. As can be seen in Fig. 10D, in the conventional implementation, adjustable capacitor 1000 is provided in a first module 1005, which is biased by a controller 1006, and as module 1004 for example a conventional module with four single pole single throw (SPST) switches may be used, of which two are employed to selectively couple capacitors 1001, 1002 to ground.

Inductor 1003 in a particular implementation may have an inductivity of 7.5 nH, capacitor 1001 may have a capacitance of 1.5 pF, and capacitor 1002 may have a capacitance of 1 pF. Adjustable capacitor 1000 may be tunable between 1.6 and 2.7 pH.

Figs. 10C and 10D show an implementation using capacitive tuner module 50. Here, in addition to capacitances C1, C2 and C3 included in the capacitive tuner module, external capacitances 1007 and 1008 each having a capacitance value of 0.5 pF are provided. Capacitance C2 is coupled in series between radio frequency source 73 and antenna 72 using terminals T1 and T9, as in particular shown in Fig. 10D. Switches SW2 and SW4 are coupled in series with capacitance C1 and C3, respectively, and are coupled between a node, which is between radio frequency source 73 and capacitor C2 and ground, by coupling terminal T3 to ground as shown. External capacitors 1007 and 1008 are coupled to terminals T10 and T8, respectively, to be coupled to ground via switch SW1 and SW3 respectively, as shown in Figs. 10C and 10D.

With both the conventional arrangement and the arrangement according to an embodiment using capacitive tuner module 50, tuning for the already mentioned first frequency band between 880 and 960 MHz (LB) and for a third frequency band (HB) between 2300 and 2700 MHz may be employed. For the first frequency band, in case of Figs. 10A and 10B, both capacitors 1001 and 1002 are coupled to ground via module 1004, and capacitance 1000 is set to 2.4 pF. For the second frequency band, only capacitor 1001 is coupled to ground via module 1004, while capacitor 1002 is disconnected and capacitor 1000 is set to 2.2 pF.

In Figs. 10C and 10D, for the first frequency band, all used switches SW1 to SW4 are on, and capacitance C2 is set to 2.4 pF. For the third frequency band, switches SW1 and SW3 are switched off, SW2 and SW4 are switched on, and capacitance C2 is set to 1.8 pF.

The solution of Figs. 10C and 10D have advantages over the solution of Figs. 10A and 10B both in terms of area requirement and in terms of losses.

The area required for controller 1006 and modules 1005, 1004 in the conventional case is about 5.26 mm², whereas, as already explained above, in a particular implementation, the area requirement for capacitive tuner module 50 may be only 2.25 mm². Furthermore, while the power loss at 30 dBm input are comparable at about 71 mW for the first frequency band, for the third frequency band for the conventional solution of Figs. 10A and 10B the power loss is 73 mW, while for the embodiment of Figs. 10C and 10D it is only 46 mW.

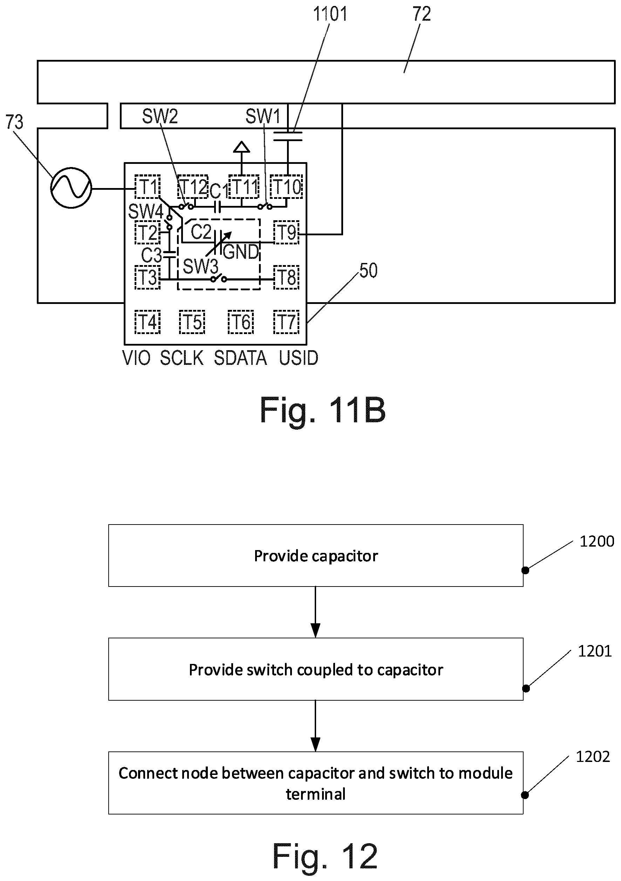

Figs. 11A and 11B illustrate a further application example using capacitive tuner module 50 of Fig. 5. Fig. 11, including Figs. 11A and 11B, shows an example for aperture tuning using capacitive tuner module 50. Fig. 11A illustrates a circuit diagram, and Fig 11B illustrates a diagram showing the implementation using module 50.

In this application example, capacitor C2 is coupled between radio frequency source 73 and antenna 72, by coupling radio frequency source 73 to terminal T1 and antenna 72 to terminal T9 of module 50. Furthermore, an external capacitance 1101 which is coupled in series with switch SW1 between antenna 72 and ground is provided. As can be seen in Fig. 11B, this is effected by coupling capacitor 1101 between antenna 72 and terminal T10 and by coupling terminal T11 to ground.

For tuning in the above-mentioned first frequency band, switch SW1 is on, and the remaining switches SW2 to SW4 (which are not used in this application) are off, and capacitance C2 is set to 2 pF. For tuning in the above-mentioned second frequency band, all switches (including SW1) are off, and C2 for example is set to 2.5 pF.

This leads to a parameter S11 which, for example at 0.88 GHz, is about -14.45 dB, and at 0.96 GHz is at about -10.34 dB. For the second frequency band, the parameter S22 is at about -11.62 dB at 1.71 GHz and at about -9.638 dB at 2.17 GHz.

Figs. 7 to 11 show that capacitive tuner module 50 may be used replacing different conventional modules and approaches with a single module, and in some cases have advantageous properties regarding area consumption and/or losses corresponding to conventional modules. Similar examples may be found for other modules discussed with reference to Figs. 1 to 4.

Fig. 12 is a flowchart illustrating a method for manufacturing a capacitive tuner circuit, for example module according to some embodiments.

The method of Fig. 12 may be used to manufacture any of the capacitive tuner modules according to embodiments discussed above, and will be described with respect to these modules for avoiding repetitions. However, the method of Fig. 12 may also be used to manufacture other modules.

At 1200, the method comprises providing a capacitor, for example capacitor 11 of Fig. 1 or capacitors C1 or C3 of Fig. 4 (4A to 4F).

At 1201, the method comprises providing a switch coupled to the capacitor, for example switch 12 of Fig. 1 and corresponding switches of other embodiments discussed. The switch coupled to the capacitor is provided between a first terminal, for example T1 of Fig. 1, and a third terminal, for example T3 of Fig. 1.

At 1202, the method comprises connecting a node between the switch and the capacitor to a terminal of the module, for example T2 of Fig. 1. It should be noted that the method may include providing further capacitors, either coupled to switches as the switch discussed with respect to Fig. 12 or also an adjustable capacitor like C2 of Fig. 4 which is coupled to two terminals. Furthermore, further switches may be provided, for example to arrive at a configuration as shown for capacitors Ck of Fig. 2. Different capacitors with different configurations may be provided, to arrive at the various embodiments discussed above.

The thus manufactured circuit or module may then be used for antenna tuning as discussed above, for example by connecting terminals to an RF source and an antenna, and then operating at least the first switch (and other switches and adjustable capacitors, if present) to achieve the desired tuning.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the appended claims.

## Claims

1. A capacitive tuner circuit (10; 40A-40F; 50), configured to adapt a radio frequency signal of a radio frequency source (73) to an antenna (70) comprising:
a first capacitor (11; C₁...Cₙ, C1, C3) coupled in series with a first switch (12; SW₁₂...SWₙ₂, SW2, SW4) between a first terminal (T1, T₁₂...Tₙ₂; T1-T10) and a third terminal (T3;
T₁₄...Tₙ₄; T1-T10) of the capacitive tuner circuit (10; 40A-40F; 50),
wherein a node between the first capacitor (11; C₁...Cₙ, C1, C3) and first switch (12; SW₁₂...SWₙ₂, SW2, SW4) is coupled to a second terminal (T2; T₁₃...Tₙ₃; T1-T10) of the capacitive tuner circuit (10; 40A-40F; 50), and
wherein the capacitive tuner circuit (10; 40A-40F; 50) is configured to be coupled to the radio frequency source (73) and the antenna (70),
**characterized by** further comprising a second switch (SW₁₁...SWₙ₁) coupled between the first terminal (T1, T₁₂...Tₙ₂; T1-T10) and a fourth terminal (T₁₁...Tₙ₁; T1-T10).

2. The capacitive tuner circuit (10; 40A-40F; 50) of claim 1, comprising:
at least one further first capacitor (11; C₁...Cₙ, C1, C3) coupled in series with a respective further first switch (12;
SW₁₂...SWₙ₂, SW2, SW4) between a respective further first terminal (T1, T₁₂...Tₙ₂; T1-T10) and a respective further third terminal (T3; T₁₄...Tₙ₄; T1-T10) of the capacitive tuner circuit (10; 40A-40F; 50),
wherein a node between the at least one further first capacitor (11; C₁...Cₙ, C1, C3) and first switch (12; SW₁₂...SWₙ₂, SW2, SW4) is coupled to a respective further second terminal (T2; T₁₃...Tₙ₃; T1-T10) of the capacitive tuner circuit (10; 40A-40F; 50).

3. The capacitive tuner circuit (10; 40A-40F; 50) of claim 2, comprising, for at least one of the at least one further first switch (12; SW₁₂...SWₙ₂, SW2, SW4), a respective further second switch (SW₁₁...SWₙ₁), coupled between the respective further first terminal (T1, T₁₂...Tₙ₂; T1-T10) and a respective further fourth terminal (T₁₁...Tₙ₁; T1-T10).

4. The capacitive tuner circuit (10; 40A-40F; 50) of claim 2 or 3, wherein at least two terminals selected from the group consisting of the third terminal (T3; T₁₄...Tₙ₄; T1-T10) and the at least one further third terminal (T3; T₁₄...Tₙ₄; T1-T10) are a common terminal.

5. The capacitive tuner circuit (10; 40A-40F; 50) of any one of claims 1 to 4, further comprising an adjustable second capacitor (30; C2) coupled between a fourth terminal (T1) and at least one of the third terminal (T3; T₁₄...Tₙ₄; T1-T10) or a fifth terminal (T2).

6. The capacitive tuner circuit (10; 40A-40F; 50) of claim 5, further comprising at least one switch (SW1, SW3) coupled between the fourth terminal (T1) and a sixth terminal (T7, T8).

7. The capacitive tuner circuit (10; 40A-40F; 50) of any one of claims 1 to 6, further comprising at least one control terminal (T4-T7) configured to receive a control signal (VIO, SCLK, SDATA, USID) for controlling at least one of the first switch or the adjustable second capacitor.

8. The capacitive tuner circuit (10; 40A-40F; 50) of any one of claims 1 to 7, wherein the capacitive tuner circuit (10; 40A-40F; 50) is a capacitive tuner module.

9. A radio frequency device, comprising:
the capacitive tuner circuit (10; 40A-40F; 50) of any one of claims 1 to 8,
the antenna (70), and
the radio frequency source (73).

10. The radio frequency device of claim 9, further comprising at least one of an external capacitance (1007; 1008; 1101) or an external inductor (70, 71; 80, 81) coupled to the capacitive tuning circuit.

11. A method for manufacturing a capacitive tuner circuit configured to adapt a radio frequency signal of a radio frequency source (73) to an antenna (70), comprising:
providing a first capacitor (11; C₁...Cₙ, C1, C3),
providing a first switch (12; SW₁₂...SWₙ₂, SW2, SW4) coupled in series to the capacitor between a first terminal (T1, T₁₂...Tₙ₂; T1-T10) and a third terminal (T3; T₁₄...Tₙ₄; T1-T10), and
connecting a node between the first capacitor (11; C₁...Cₙ, C1, C3) and the first switch (12; SW₁₂...SWₙ₂, SW2, SW4) to a second terminal (T2; T₁₃...Tₙ₃; T1-T10) of the capacitive tuner circuit (10; 40A-40F; 50) (10; 40A-40F; 50), **characterized by**
providing a second switch (SW₁₁...SWₙ₁) coupled between the first terminal (T1, T₁₂...Tₙ₂; T1-T10) and a fourth terminal (T₁₁...Tₙ₁; T1-T10)

12. The method of claim 11, wherein the method is configured to manufacture the capacitive tuner circuit (10; 40A-40F; 50) of any one of claims 1 to 6.

13. A method of tuning the radio frequency device of claim 9 or 10, comprising:
operating at least the first switch of the capacitive tuning circuit to tune the antenna (70) , wherein the capacitive tuning circuit is coupled to the radio frequency source and the antenna.

14. Use of the capacitive tuner circuit of any one of claims 1 to 8 for tuning the antenna (70) , wherein the capacitive tuning circuit is coupled to the radio frequency source and the antenna.

## Patentansprüche

1. Kapazitive Abstimmschaltung (10; 40A-40F; 50), die konfiguriert ist, um ein Hochfrequenzsignal einer Hochfrequenzquelle (73) an eine Antenne (70) anzupassen, umfassend:
einen ersten Kondensator (11; C₁...Cₙ, C1, C3), der mit einem ersten Schalter (12; SW₁₂...SWₙ₂, SW2, SW4) zwischen einem ersten Anschluss (T1, T₁₂...Tₙ₂; T1-T10) und einem dritten Anschluss (T3; T₁₄...Tₙ₄; T1-T10) der kapazitiven Abstimmschaltung (10; 40A-40F; 50) in Reihe geschaltet ist,
wobei ein Knoten zwischen dem ersten Kondensator (11; C₁...Cₙ, C1, C3) und dem ersten Schalter (12; SW₁₂...SWₙ₂, SW2, SW4) mit einem zweiten Anschluss (T2; T₁₃...Tₙ₃; T1-T10) der kapazitiven Abstimmschaltung (10; 40A-40F; 50) gekoppelt ist, und
wobei die kapazitive Abstimmschaltung (10; 40A-40F; 50) konfiguriert ist, um mit der Hochfrequenzquelle (73) und der Antenne (70) gekoppelt zu werden,
**dadurch gekennzeichnet, dass** sie ferner einen zweiten Schalter (SW₁₁...SWₙ₁) umfasst, der zwischen dem ersten Anschluss (T1, T₁₂...Tₙ₂; T1-T10) und einem vierten Anschluss (T₁₁...Tₙ₁; T1-T10) gekoppelt ist.

2. Kapazitive Abstimmschaltung (10; 40A-40F; 50) nach Anspruch 1, umfassend:
mindestens einen weiteren ersten Kondensator (11; C₁...Cₙ, C1, C3), der mit einem jeweiligen weiteren ersten Schalter (12; SW₁₂...SWₙ₂, SW2, SW4) zwischen einem jeweiligen weiteren ersten Anschluss (T1, T₁₂...Tₙ₂; T1-T10) und einem jeweiligen weiteren dritten Anschluss (T3; T₁₄...Tₙ₄; T1-T10) der kapazitiven Abstimmschaltung (10; 40A-40F; 50) in Reihe geschaltet ist,
wobei ein Knoten zwischen dem mindestens einen weiteren ersten Kondensator (11; C₁...Cₙ, C1, C3) und dem ersten Schalter (12; SW₁₂...SWₙ₂, SW2, SW4) mit einem jeweiligen weiteren zweiten Anschluss (T2; T₁₃...Tₙ₃; T1-T10) der kapazitiven Abstimmschaltung (10; 40A-40F; 50) gekoppelt ist.

3. Kapazitive Abstimmschaltung (10; 40A-40F; 50) nach Anspruch 2, umfassend für mindestens einen des mindestens einen weiteren ersten Schalters (12; SW₁₂...SWₙ₂, SW2, SW4) einen jeweiligen weiteren zweiten Schalter (SW₁₁...SWₙ₁), der zwischen dem jeweiligen weiteren ersten Anschluss (T1, T₁₂...Tₙ₂; T1-T10) und einem jeweiligen weiteren vierten Anschluss (T₁₁...Tₙ₁; T1-T10) gekoppelt ist.

4. Kapazitive Abstimmschaltung (10; 40A-40F; 50) nach Anspruch 2 oder 3, wobei mindestens zwei Anschlüsse, die aus der Gruppe ausgewählt sind, die aus dem dritten Anschluss (T3; T₁₄...Tₙ₄; T1-T10) und dem mindestens einen weiteren dritten Anschluss (T3; T₁₄...Tₙ₄; T1-T10) besteht, ein gemeinsamer Anschluss sind.

5. Kapazitive Abstimmschaltung (10; 40A-40F; 50) nach einem der Ansprüche 1 bis 4, ferner umfassend einen einstellbaren zweiten Kondensator (30; C2), der zwischen einem vierten Anschluss (T1) und mindestens einem des dritten Anschlusses (T3; T₁₄...Tₙ₄; T1-T10) oder einem fünften Anschluss (T2) gekoppelt ist.

6. Kapazitive Abstimmschaltung (10; 40A-40F; 50) nach Anspruch 5, ferner umfassend mindestens einen Schalter (SW1, SW3), der zwischen dem vierten Anschluss (T1) und einem sechsten Anschluss (T7, T8) gekoppelt ist.

7. Kapazitive Abstimmschaltung (10; 40A-40F; 50) nach einem der Ansprüche 1 bis 6, ferner umfassend mindestens einen Steueranschluss (T4-T7), der konfiguriert ist, um ein Steuersignal (VIO, SCLK, SDATA, USID) zum Steuern mindestens eines des ersten Schalters oder des einstellbaren zweiten Kondensators zu empfangen.

8. Kapazitive Abstimmschaltung (10; 40A-40F; 50) nach einem der Ansprüche 1 bis 7, wobei die kapazitive Abstimmschaltung (10; 40A-40F; 50) ein kapazitives Abstimmmodul ist.

9. Hochfrequenzvorrichtung, umfassend:
die kapazitive Abstimmschaltung (10; 40A-40F; 50) nach einem der Ansprüche 1 bis 8,
die Antenne (70), und
die Hochfrequenzquelle (73).

10. Hochfrequenzvorrichtung nach Anspruch 9, ferner umfassend mindestens eine einer externen Kapazität (1007; 1008; 1101) oder einer externen Induktivität (70, 71; 80, 81), die mit der kapazitiven Abstimmschaltung gekoppelt ist.

11. Verfahren zum Herstellen einer kapazitiven Abstimmschaltung, die konfiguriert ist, um ein Hochfrequenzsignal einer Hochfrequenzquelle (73) an eine Antenne (70) anzupassen, umfassend:
Bereitstellen eines ersten Kondensators (11; C₁...Cₙ, C1, C3), Bereitstellen eines ersten Schalters (12; SW₁₂...SWₙ₂, SW2, SW4), der mit dem Kondensator zwischen einem ersten Anschluss (T1, T₁₂...Tₙ₂; T1-T10) und einem dritten Anschluss (T3; T₁₄...Tₙ₄; T1-T10) in Reihe geschaltet ist, und
Verbinden eines Knotens zwischen dem ersten Kondensator (11; C₁...Cₙ, C1, C3) und dem ersten Schalter (12; SW₁₂...SWₙ₂, SW2, SW4) mit einem zweiten Anschluss (T2; T₁₃...Tₙ₃; T1-T10) der kapazitiven Abstimmschaltung (10; 40A-40F; 50) (10; 40A-40F; 50), **gekennzeichnet durch**
Bereitstellen eines zweiten Schalters (SW₁₁...SWₙ₁), der zwischen dem ersten Anschluss (T1, T₁₂...Tₙ₂; T1-T10) und einem vierten Anschluss (T₁₁...Tₙ₁; T1-T10) gekoppelt ist.

12. Verfahren nach Anspruch 11, wobei das Verfahren konfiguriert ist, um die kapazitive Abstimmschaltung (10; 40A-40F; 50) nach einem der Ansprüche 1 bis 6 herzustellen.

13. Verfahren zum Abstimmen der Hochfrequenzvorrichtung nach Anspruch 9 oder 10, umfassend:
Betreiben mindestens des ersten Schalters der kapazitiven Abstimmschaltung, um die Antenne (70) abzustimmen, wobei die kapazitive Abstimmschaltung mit der Hochfrequenzquelle und der Antenne gekoppelt ist.

14. Verwendung der kapazitiven Abstimmschaltung nach einem der Ansprüche 1 bis 8 zum Abstimmen der Antenne (70), wobei die kapazitive Abstimmschaltung mit der Hochfrequenzquelle und der Antenne gekoppelt ist.

## Revendications

1. Un circuit (10 ; 40A-40F ; 50) de syntoniseur capacitif configuré pour adapter un signal de fréquence radio d'une source (73) de fréquence radio à une antenne (70) comprenant :
un premier condensateur (11 ; C₁...Cₙ, C1, C3) monté en série avec un premier interrupteur (12 ; SW₁₂...SWₙ₂, SW2, SW4) entre une première borne (T1, T₁₂...Tₙ₂ ; T1-T10) et une troisième borne (T3 ; T₁₄...Tₙ₄ ; T1-T10) du circuit (10 ; 40A-40F ; 50) de syntoniseur capacitif,
dans lequel un nœud, entre le premier condensateur (11 ; C₁...Cₙ, C1, C3) et un premier interrupteur (12 ; SW₁₂...SWₙ₂, SW2, SW4), est connecté à une deuxième borne (T2 ; T₁₃...Tₙ₃ ; T1-T10) du circuit (10 ; 40A-40F ; 50) de syntoniseur capacitif, et
dans lequel le circuit (10 ; 40A-40F ; 50) de syntoniseur capacitif est configuré pour être connecté à la source (73) de fréquence radio et à l'antenne (70),
**caractérisé en ce qu'**il comprend en outre un deuxième interrupteur (SW₁₁...SWₙ₁) monté entre la première borne (T1, T₁₂...Tₙ₂ ; T1-T10) et une quatrième borne (T₁₁...Tₙ₁ ; T1-T10).

2. Le circuit (10 ; 40A-40F ; 50) de syntoniseur capacitif de la revendication 1, comprenant :
au moins un autre premier condensateur (11 ; C₁...Cₙ, C1, C3) monté en série avec un autre premier interrupteur (12 ; SW₁₂...SWₙ₂, SW2, SW4) respectif entre une autre première borne (T1, T₁₂...Tₙ₂ ; T1-T10) respective et une autre troisième borne (T3 ; T₁₄...Tₙ₄ ; T1-T10) respective du circuit (10 ; 40A-40F ; 50) de syntoniseur capacitif,
dans lequel un nœud, entre le au moins un autre premier condensateur (11 ; C₁...Cₙ, C1, C3) et un premier interrupteur (12 ; SW₁₂...SWₙ₂, SW2, SW4), est connecté à une autre deuxième borne (T2 ; T₁₃...Tₙ₃ ; T1-T10) respective du circuit (10 ; 40A-40F ; 50) de syntoniseur capacitif.

3. Le circuit (10 ; 40A-40F ; 50) de syntoniseur capacitif de la revendication 2, comprenant, pour au moins l'un du au moins un autre premier interrupteur (12 ; SW₁₂...SWₙ₂, SW2, SW4), un autre deuxième interrupteur (SW₁₁...SWₙ₁) respectif monté entre l'autre première borne (T1, T₁₂...Tₙ₂ ; T1-T10) respective et une autre quatrième borne (T₁₁...Tₙ₁ ; T1-T10) respective.

4. Le circuit (10 ; 40A-40F ; 50) de syntoniseur capacitif de la revendication 2 ou 3, dans lequel au moins deux bornes, choisies dans le groupe consistant en la troisième borne (T3 ; T₁₄...Tₙ₄ ; T1-T10) et la au moins une autre troisième borne (T3 ; T₁₄...Tₙ₄ ; T1-T10), sont une borne commune.

5. Le circuit (10 ; 40A-40F ; 50) de syntoniseur capacitif de l'une quelconque des revendications 1 à 4, comprenant en outre un deuxième condensateur (30 ; C2) réglable monté entre une quatrième borne (T1) et au moins l'une de la troisième borne (T3 ; T₁₄...Tₙ₄ ; T1-T10) ou une cinquième borne (T2).

6. Le circuit (10 ; 40A-40F ; 50) de syntoniseur capacitif de la revendication 5, comprenant en outre au moins un interrupteur (SW1, SW3) monté entre la quatrième borne (T1) et une sixième borne (T7, T8).

7. Le circuit (10 ; 40A-40F ; 50) de syntoniseur capacitif de l'une quelconque des revendications 1 à 6, comprenant en outre au moins une borne (T4-T7) de commande configurée pour recevoir un signal (VIO, SCLK, SDATA, USID) de commande pour commander au moins l'un du premier interrupteur ou du deuxième condensateur réglable.

8. Le circuit (10 ; 40A-40F ; 50) de syntoniseur capacitif de l'une quelconque des revendications 1 à 7, dans lequel le circuit (10 ; 40A-40F ; 50) de syntoniseur capacitif est un module de syntoniseur capacitif.

9. Un dispositif de fréquence radio, comprenant :
le circuit (10 ; 40A-40F ; 50) de syntoniseur capacitif de l'une quelconque des revendications 1 à 8,
une antenne (70), et
la source (73) de fréquence radio.

10. Le dispositif de fréquence radio de la revendication 9, comprenant en outre au moins l'un d'une capacité (1007 ; 1008 ; 1101) extérieure ou d'une inductance (70, 71 ; 80, 81) extérieure connectée au circuit de syntoniseur capacitif.

11. Un procédé de fabrication d'un circuit de syntoniseur capacitif configuré pour adapter un signal de fréquence radio d'une source (73) de fréquence radio à une antenne (70), comprenant :
se procurer un premier condensateur (11 ; C₁...Cₙ, C1, C3),
se procurer un premier interrupteur (12 ; SW₁₂...SWₙ₂, SW2, SW4) monté en série avec le condensateur entre une première borne (T1, T₁₂...Tₙ₂ ; T1-T10) et une troisième borne (T3 ; T₁₄...Tₙ₄ ; T1-T10), et connecter un nœud, entre le premier condensateur (11 ; C₁...Cₙ, C1, C3) et le premier interrupteur (12 ; SW₁₂...SWₙ₂, SW2, SW4), à une deuxième borne (T2 ; T₁₃...Tₙ₃ ; T1-T10) du circuit (10 ; 40A-40F ; 50) de syntoniseur capacitif, **caractérisé en ce qu'**il consiste à prévoir un deuxième interrupteur (SW₁₁...SWₙ₁) monté entre la première borne (T1, T₁₂...Tₙ₂ ; T1-T10) et une quatrième borne (T₁₁...Tₙ₁; T1-T10).

12. Le procédé de la revendication 11, dans lequel le procédé est configuré pour fabriquer le circuit (10 ; 40A-40F ; 50) de syntoniseur capacitif suivant l'une quelconque des revendications 1 à 6.

13. Un procédé de syntonisation du dispositif de fréquence radio de la revendication 9 ou 10, comprenant :
faire fonctionner au moins le premier interrupteur de circuit de syntonisation capacitif pour syntoniser l'antenne (70), dans lequel le circuit de syntonisation est connecté à la source de fréquence radio et à l'antenne.

14. Utilisation du circuit de syntoniseur capacitif suivant l'une quelconque des revendications 1 à 8, pour syntoniser l'antenne (70), dans lequel le circuit de syntonisation capacitif est connecté à la source de fréquence radio et à l'antenne.
